# EUROPEAN PATENT SPECIFICATION

(11) **EP 0 597 514 B1**
(45) Date of publication and mention of the grant of the patent: **06.08.1997**
(21) Application number: 93202918.4
(22) Date of filing: 18.10.1993
(51) Int. Cl.: H01L 29/732, H01L 29/06

(54) **Vertical PNP semiconductor device**
Vertikale PNP Halbleiteranordnung
Dispositif semi-conducteur PNP vertical

(30) Priority: 09.11.1992 US 973503
(43) Date of publication of application: 18.05.1994
(73) Proprietor: DELCO ELECTRONICS CORPORATION, Kokomo Indiana 46902 (US)
(72) Inventor: Fruth, John Rothgeb, Kokomo, Indiana 46902 (US); Gose, Mark Wendell, Kokomo, Indiana 46902 (US); Kaszyca, John Kevin, Lafayette, Indiana 47905 (US)
(74) Representative: Denton, Michael John

(56) References cited:
- EP-A- 0 098 175
- EP-A- 0 413 479

## Description

This invention relates to semiconductor devices, and more particularly to a novel structure for vertical PNP devices achieving improved performance.

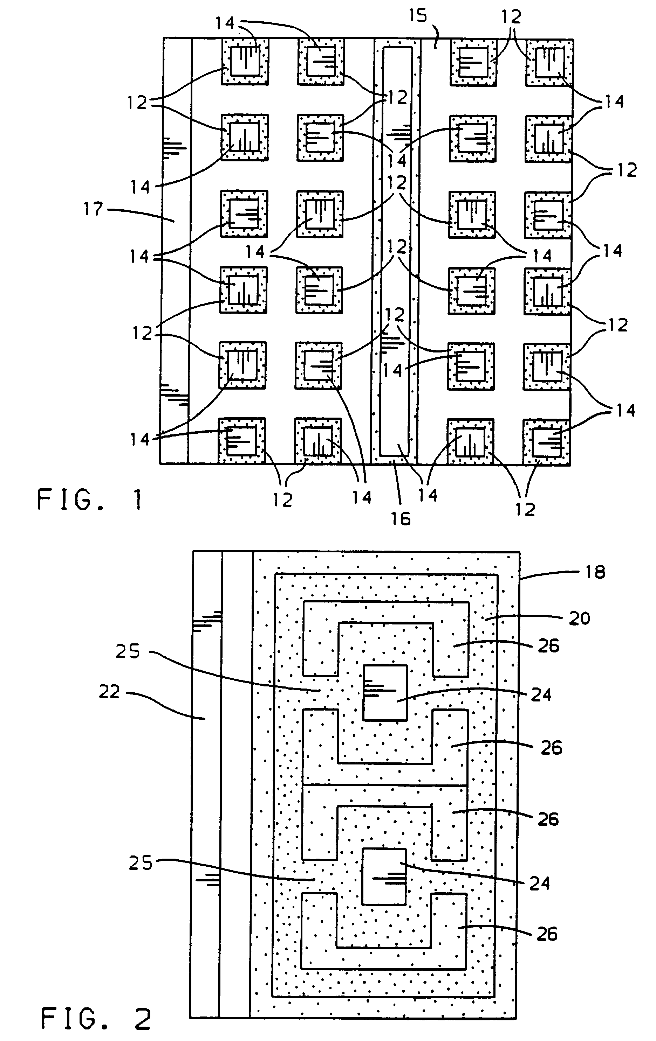

A prior art PNP device 10 is shown in Figure 1. Such a PNP device uses small squares of P+ emitter diffusion 12, contacts 14, N+ base 16, and N-type base material 15 and P+ collector 17 all connected together to form a power device. The contacts 14 are near the edge of the emitter diffusion and cause the device 10 to have little emitter resistance to ballast it against secondary breakdown. A secondary breakdown phenomena occurs in bipolar devices when one part of the device gets hotter than another part. This causes the one part of the device to flow more current than the cooler part of the device. This in turn makes the hot part of the device get even hotter. This continues until the one part is so hot that it destroys the device. A well-known method to improve the durability of PNP devices is to incorporate ballast resistance in the emitter leg of the transistor. This will tend to shut-off any part of the device trying to source excessive current.

Prior art NPN transistors as shown in Figure 2 include a base 18, emitter 20, collector 22, contacts 24 and often utilise an "H" and/or "U" structure 26 to restrict current build up. In such a system, the emitter diffusion is put down with a "H" shape hole in the emitter diffusion. The "H" shaped holes in the emitter diffusion define resistive areas 25 in the emitter diffusion where there is a lesser area for current to flow in route from the contacts 24 to the collector 22. All the current flows through the resistive areas 25 of the diffusion before reaching the active transistor area at the periphery thereby restricting current build up. For high reverse bias conditions (high voltage operations), only the outer part of the emitter is active as a source of current. The resistive areas in NPN "H" emitter structures are only on two sides, because the emitter sheet resistance is very low. This causes the device to be less efficient because there is series resistance to the remaining periphery of the emitter.

These "H" shaped emitter structures, are not desirable for vertical PNP devices because such structures result in too much emitter resistance. This is because the emitter sheet resistance for PNP devices is much higher than that of NPN devices (5-20 times greater). This would result in higher saturation resistance and a less efficient device.

EP-A-0413479 discloses an integrated circuit with one or more multi-emitter power transistors in which hot spots are avoided by providing a ballast resistor in series with each emitter.

The present invention aims to overcome the deficiencies of the prior art.

A semiconductor device according to the present invention is set out in claim 1.

The present invention relates to vertical PNP semiconductor devices having emitters with holes formed in the emitter diffusion in a radial pattern. The restricted or lesser area between adjacent holes define a resistive emitter diffusion section. Thus, the resistive emitter diffusion sections are also in a radial pattern. Such devices include transistors. The radial pattern of resistive emitter diffusion sections results in a lower emitter ballast resistance than "H"-type structures. This is desirable because of the higher emitter sheet resistance of PNP devices. This allows all the periphery of the emitter to be active, not just two sides as in "H" structure NPN devices. The present invention device has improved emitter ballast resistance while at the same time remaining efficient with low saturation resistance.

The present invention will now be described, by way of example, with reference to the accompanying drawings, in which:-
Figure 1 is an illustration of a prior art vertical PNP device as described above;
Figure 2 is an illustration of a prior art NPN device as described above;
Figure 3 is an illustration of a vertical PNP device, such as a transistor, according to the present invention having radially positioned kiwi-shaped emitters;
Figure 4 is an illustration of a kiwi-shaped emitter having rectangular-shaped holes defining resistive emitter diffusion sections radially positioned according to an embodiment of the present invention;
Figure 5 is an illustration of an emitter having "half seed" holes defining resistive emitter diffusion sections in a radial pattern according to another embodiment of the present invention;
Figure 6 is an illustration of an emitter having a full, fan blade-shaped holes defining resistive emitter diffusion section in a radial pattern according to a further embodiment of the present invention; and
Figure 7 is an illustration of another emitter having a fan blade-shaped holes defining resistive emitter diffusion section in a radial pattern according to a still further embodiment of the present invention.

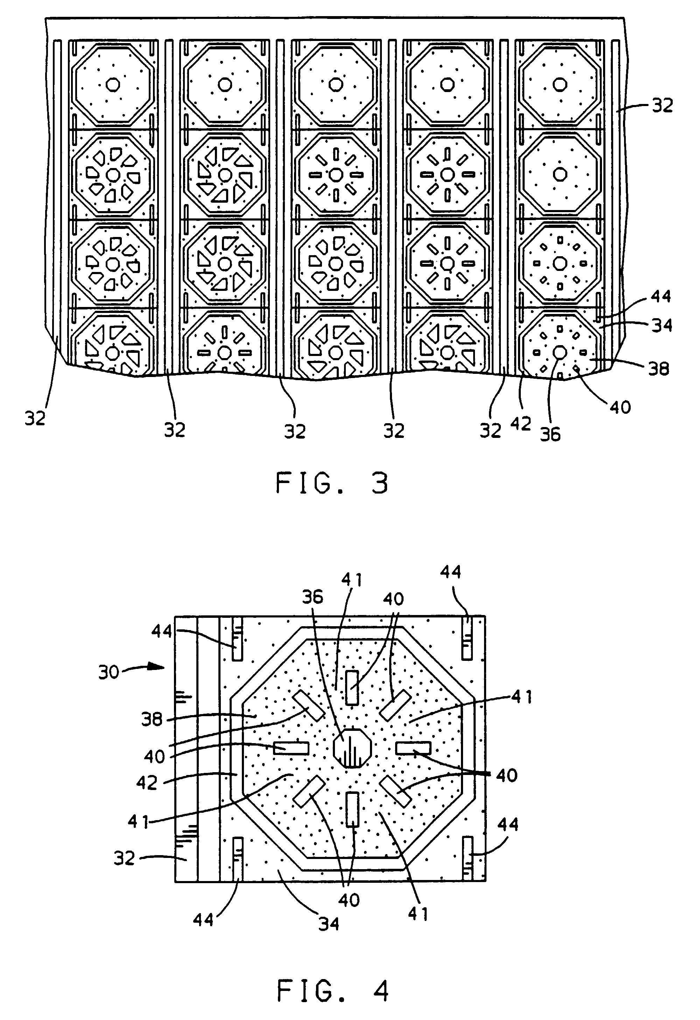

A device according to the present invention may be called a kiwi vertical PNP device because it resembles a kiwi fruit cut in half. Holes are radially positioned like seeds in a kiwi fruit. A silicon material which has been doped with an impurity to make it N-type is used to form a base for the device. A P-type diffusion material is introduced in an octagonal pattern to form an emitter of the device, like the meat of a kiwi. The holes (or seeds of the kiwi-shaped device) are not doped with a P-type material, so they remain N-type forming a junction. The holes (or seeds) could also be formed by forming a dielectric insulating material in the base. A contact to the emitter is located at the centre. As shown in Figure 3, each kiwi vertical PNP device includes a collector 32, a base 34, a contact 36 and an emitter 38 having holes 40.

Figure 4 is an enlargement a vertical PNP device 30 of Figure 3 including a collector 32, base 34, contact 36, an emitter 38 and "seeds" 40 formed therein to define resistive emitter diffusion sections 41 between "seeds" 40 and in a radial pattern. A N-epitaxial area 42 may isolate the P+ type emitter 38 from the N+ base 34. Base contact pads 44 are formed in the base 34. The contact 36 is a metal-silicon interface. The emitter 38 is a P-type material and the seeds 40 are N-type base material. The contact 36, emitter 38, and seeds or holes 40 are formed by selective ion implant techniques and oxide etch techniques known to those skilled in the art. For an emitter 38 as shown in Figure 4, the rectangular-shaped holes have length ranging from about 10 µm to about 50 µm and a width ranging from about 4 µm to about 20 µm, and preferably a length of about 14 µm and a width of about 6 µm. The rectangular-shaped "seeds" 40 are centred radially a distance of about 16 µm from the centre of the contact 36.

Figures 4-7 are of similar construction with the difference being the shape of the holes 40 in the P-type emitter 38. The collector 32, contact 36, base 34, and holes 40 may be formed in a silicon material by selective doping techniques. The contact 36, base 34 and holes 40 are in the same plane of the silicon material so that the current flows laterally from the contact, through the emitter diffusion and around the holes towards the collector 32.

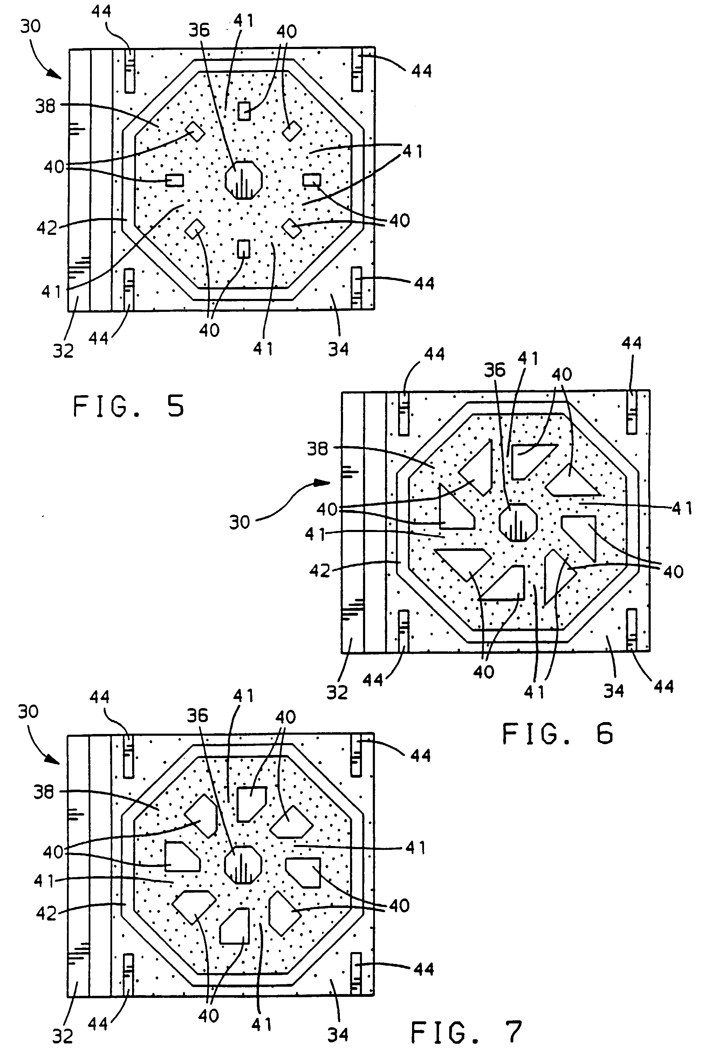

Figure 5 is an illustration of a vertical PNP device 30 according to the present invention having "half seeds". In this structure, the holes or seeds are half the size that of Figure 4. For example, the "half seed" holes have a length ranging from about 5 µm to about 25 µm and a width ranging from about 4 µm to about 20 µm, and preferably a length of 7 µm and a width of 6 µm. The "half seed" structure provides a greater area in the emitter diffusion between adjacent holes 40 for current to flow and to produce less ballast resistance. The "half seed" structure can be used around the periphery of a power device where the temperature is lower.

Figure 6 illustrates a vertical PNP device 30 according to the present invention having holes 40 shaped in a full fan blade configuration. In this configuration the rectangular-shaped seed as illustrated in Figure 4 is extended along one end a distance ranging from about 10 µm to about 50 µm and preferably 16 µm. The resulting partial fan blade seed 40 has a trapezium shape. This configuration is advantageous because the lesser area in the emitter diffusion between adjacent holes 40 for current to flow and thus has the most ballast resistance. Thus, it can be used in the centre of a power device where the temperature is the highest.

Figure 7 illustrates a vertical PNP device 30 according to the present invention wherein the rectangular-shaped seeds of Figure 4 are extended along one end a length ranging from about 0 µm to about 16 µm and preferably about 8 µm to form a pentagon-shaped fan blade seed 40. The pentagon-shaped fan blade seed is advantageous because of the ballast resistance can be varied between the standard kiwi structure and the fan blade structure. These can be used to better even out the temperature profile across the power device.

The following illustrates selective advantages of the present invention.

The ruggedness of the kiwi vertical PNP device as illustrated in Figure 3 was compared with a conventional PNP device as illustrated in Figure 1. Large, 6.45 mm² (10,000 sq. mil.) power vertical PNP transistors were fabricated for the kiwi vertical PNP device as illustrated in Figure 3 and for a conventional PNP transistor as illustrated in Figure 1. All measurements were made for 10 millisecond durations and at 40 volts, with the current being changed to vary the power levels until the device exploded. The conventional PNP as illustrated in Figure 1, which has no ballast resistance, was found to withstand 72 watts before failure. The kiwi vertical PNP device as illustrated in Figure 3 was found to withstand 360 watts. This represents a five fold increase in the ruggedness of kiwi vertical PNP transistors over conventional PNP transistors.

## Claims

1. A vertical PNP semiconductor device (30) comprising a base region (34); a collector region (32), and an emitter region (38) having a contact (36) and a plurality of holes (40) formed in the emitter region and radially positioned with respect to the contact so that a resistive emitter region section (41) is defined between adjacent holes and so that the current flow between the contact and the collector is restricted in the resistive emitter region section.

2. A semiconductor device as claimed in claim 1, wherein the holes (40) are substantially equally spaced apart from each other.

3. A semiconductor device as claimed in claim 1 or claim 2, wherein each hole (40) is rectangularly shaped.

4. A semiconductor device as claimed in claim 1 or claim 2, wherein each hole (40) has a trapezium shape.

## Patentansprüche

1. Eine vertikale PNP-Halbleitervorrichtung (30), welche einen Basisbereich (34); einen Kollektorbereich (32), und einen Emitterbereich (38) enthält, der einen Kontakt (36) und eine Vielzahl von Löchern (40) besitzt, welche dergestalt in dem Emitterbereich gebildet und radial bezüglich des Kontakts angeordnet sind, daß ein widerstandsbehafteter Abschnitt (41) des Emitterbereichs zwischen benachbarten Löchern festgelegt ist und daß der Stromfluß zwischen dem Kontakt und dem Kollektor in dem widerstandsbehafteten Abschnitt des Emitterbereichs begrenzt ist.

2. Eine Halbleitervorrichtung wie in Anspruch 1 beansprucht, in welcher die Löcher (40) im wesentlichen gleich voneinander beabstandet sind.

3. Eine Halbleitervorrichtung wie in Anspruch 1 oder Anspruch 2 beansprucht, in welcher jedes Loch (40) rechteckig ist.

4. Eine Halbleitervorrichtung wie in Anspruch 1 oder Anspruch 2 beansprucht, in welcher jedes Loch (40) die Form eines Trapezes besitzt.

## Revendications

1. Dispositif à semi-conducteur PNP vertical (30) comportant une région de base (34), une région de collecteur (32), et une région d'émetteur (38) ayant un contact (36) et une pluralité de trous (40) formés dans la région d'émetteur et positionnés radialement par rapport au contact de telle sorte qu'une section résistive de région d'émetteur (41) soit définie entre trous adjacents et de telle sorte que la circulation d'un courant entre le contact et le collecteur soit limitée dans la section résistive de la région d'émetteur.

2. Dispositif à semi-conducteurs selon la revendication 1, dans lequel les trous (40) sont à peu près également espacés les uns des autres.

3. Dispositif à semi-conducteurs selon la revendication 1 ou 2, dans lequel chaque trou (40) a une forme rectangulaire.

4. Dispositif à semi-conducteurs selon la revendication 1 ou 2, dans lequel chaque trou (40) a une forme trapézoïdale.
